Europäisches Patentamt

European Patent Office

Office européen des brevets

(11) Publication number: **0 456 912 A1**

# EUROPEAN PATENT APPLICATION

(21) Application number: 90201217.8

(51) Int. Cl.⁵: **H05K 1/03**

(22) Date of filing: **15.05.90**

(43) Date of publication of application:
**21.11.91 Bulletin 91/47**

(84) Designated Contracting States:
**AT BE CH DE DK ES FR GB IT LI NL SE**

(71) Applicant: **STAMICARBON B.V.**
**Mijnweg 1**
**NL-6167 AC Geleen(NL)**

(72) Inventor: **Shinonome, Osami, c/o Unitika Ltd.**
**Chuo Kenkyusho 23, Kozakura**
**Uji, Uji-shi, Kyoto(JP)**
Inventor: **Kishida, Minoru, c/o Unitika Ltd.**
**Chuo Kenkyusho 23, Kozakura**
**Uji, Uji-shi, Kyoto(JP)**
Inventor: **Izumi, Tomoyuki, c/o Unitika Ltd.**
**Chuo Kenkyusho 23, Kozakura**
**Uji, Uji-shi, Kyoto(JP)**

(54) Polyamide type laminated film.

(57) The invention concerns a biaxially oriented thermoplastic type laminated film having an electrolytic copper foil layer laminated on at least one side, wherein the film comprises a thermoplastic resin composed essentially of polytetramethylene adipamide and wherein the dry heat shrinkage of the film measured under the condition of 160 °C x 15 minutes, shows a value of at most 0,5%, in longitudinal and transverse direction.
The film is especially suited for flexible circuit boards.

The invention relates to a biaxially oriented thermoplastic type laminated film, having a conductive metal layer laminated on at least one side.

Such a film is known from FR-A-2400820. Herein a flexible laminated plate for printed circuits is described comprising a flexible plastic film of a polyimide resin on which a Cu-foil is posted to form contacts, terminals and circuit parts and an elastic metal layer of e.g. Cd-Cu alloy which is applied to the back side of the plastic film.

A drawback of such a plate is the use of polyimide as thermoplastic film. The polyimide film does satisfy almost all required properties but it has the drawback that the costs of the starting materials are high and the complexity of the film-forming method adds to the cost.

The object of the invention is therefore to provide a thermoplastic film which does statisfy all requirements for flexible printed circuits, but does not show the problem inherent to polyimide films.

The object is achieved in that the film comprises a thermoplastic resin composed essentially of polytetramethylene adipamide and wherein the dry heat shrinkage of the film measured after 15 minutes at $160^\circ$ C, shows a value of at most ± 0.5% in the longitudinal and the transverse direction.

It has been found that the film according to the invention, despite the crystallizability of the polytetramethylene adipamide, is suitable for flexible printed circuits (FPC) and does satisfy the required properties especially regarding dimensional stability and heat resistance.

In the present invention, the polytetramethylene adipamide or the polyamide composed essentially thereof, is obtained by polycondensation of tetramethylene diamine and adipic acid or by copolycondensation thereof as the main component with other polyamide-forming monomer. In either case, the desired product can be produced by a conventional known method. As the copolycondensation component, one or more members selected from the group consisting of aminocarboxylic acids such as $\epsilon$-aminocaproic acid, $\omega$-aminododecanoic acid and aminobenzen carboxylic acid, dicarboxylic acids such as sebacic acid, terephthalic acid, naphthalene dicarboxylic acid, and diamine components such as hexamethylenediamine, phenylenediamine, xylylenediamine and bis(p-aminocyclohexyl)methane, may suitably be selected. In order not to impair the high melting point (about $292^\circ$ C) as a characteristic of the polytetramethylene adipamide, the amount of such copolycondensation component should be not more than 20 mol%, preferably not more than 15 mol%, to prevent a drop of the melting point. Further, it is effective to make the material in the form of a block copolyamide such as a block copolyamide of polytetramethylene adipamide with polyhexamethylene adipamide, or in the form of a polyamide mixture, for example, by blending polytetramethylene adipamide with poly-$\epsilon$-capramide. In such a case, the amount of the polytetramethylene adipamide component should preferably be at least 60% by weight, more preferably at least 70% by weight, of the total.

A feature of the polyamide film in the present invention, is that it is a biaxially oriented film whereby the dry heat shrinkage under the measuring condition of $160^\circ$ C during 15 minutes shows a value of not more than ± 0.5% in each of the longitudinal and transverse directions.

Firstly, with respect to the necessity of the biaxially oriented film, it should be pointed out that with a non-stretched (non-oriented) film or with a monoaxially stretched film, good results can not be imparted to the final laminated film. The mechanical properties or their balance will be inferior.

On the other hand, if the heat shrinkage is outside the above range, a deformation will occur during soldering or during use at high temperatures. Here, with respect to the meaning of (±), (+) means a shrinkage and (-) means an expansion.

The biaxially oriented polyamide film in the present invention is preferably produced by a process comprising a step of producing a non-stretched film by a melt film-forming method, a quenching step of the non-stretched film and a simultaneous biaxial stretching step by a flat method and a heat treatment step.

The polytetramethylene adipamide type polymer is a polymer having high orientation and a high crystallization rate. Therefore, it is extremely effective to employ a simultaneous biaxial stretching method. Specifically, polytetramethylene adipamide or a polyamide composed essentially thereof is melt-extruded by a T-die method at a temperature of between 290 and $330^\circ$ C, followed by cooling the film product by a casting roller maintained at a temperature of not higher than $10^\circ$ C. For example, as disclosed in Japanese Unexamined Patent Publication No. 220731/1975, the film product is cooled at a rate of $105^\circ$ C/min within a temperature range of from $10^\circ$ C below the melting point to $100^\circ$ C below the melting point to obtain a non-stretched film. The non-stretched film is immersed in water for swelling, (the polytetramethylene adipamide has a water absorptivity of about 8% and it is advisable to let the non-stretched film absorb water in an amount of at least about 2%), then simultaneously biaxially stretched by a flat method at a temperature of between 50 and $200^\circ$ C, preferably between 70 and $180^\circ$ C, at a stretching ratio in longitudinal and transverse direction of between 1.5 and 5.0 times, preferably, between 2.0 and 4.0 times, and at an area stretching ratio of between 3 and 20 times, preferably between 4 and 15 times, and thereafter subjected to a heat treatment at a constant temperature of between 200 and 280°C, preferably between 210 and 270°C, under a tension of not more than about 15% or tensionless conditions. To obtain the biaxially oriented polyamide film of the present invention, the above conditions may be suitably combined.

As the conductive metal layer in the present invention, copper, aluminium, etc. may be used. It is particularly preferred to employ a copper foil. All kinds of copper foil can be used, for instance an electrolytic copper foil and a rolled copper foil. Usually, the electrolytic copper foil is employed. However, when bending properties are required the rolled copper foil is preferably used. When such a copper foil is used, it is common to laminate it with the polyamide biaxially oriented film by means of an adhesive. It is preferred to use a surface-oxydized copper foil having good adhesive properties. The adhesive is preferably one which not only has a good adhesion to the biaxially oriented polyamide film and the conductive metal foil, but also has excellent electrical properties and heat resistance. Such an adhesive may suitably be selected from urethane type, polyamide type, epoxy type, phenyl type, acryl type, silicon type, triazine type and imide type adhesives. The bonding can be obtained by continuously coating a solution of the above adhesive to the biaxially oriented polyamide film by means of a roll coater, followed by heating to evaporate the solvent and pressing the film on the conductive metal foil by heat rollers.

It is also possible to form the conductive metal layer by electroless plating. In such a case, the film is subjected to a surface-activating treatment by conventional methods and then immersed in an electroless plating bath, particularly an electroless copper plating bath. When the thickness of the copper layer should be less than about 10 $\mu$m, electroless plating is preferred. However, when a thicker copper layer is required, the electroless plating may be followed by electrolytic plating. In order to improve the adhesion between the copper layer and the polyamide biaxially oriented film, it is advisable to preliminarily subject the film to an etching treatment.

Examples 1 to 5 and comparative examples 1 to 3

Homo-tetramethylene adipamide having $\eta_{rel}$ = 3.4 was melted and formed into a film at a polymer temperature of 310°C and quenched by casting rollers at -10°C to obtain a non-stretched film having a thickness of 400$\mu$m. This non-stretched film was left to stand in water at 20°C for 3 hours (water absorption was about 4%), and then subjected to a simultaneous biaxial stretching treatment at a stretching speed of 20 m/min by means of a tenter and further to a heat treatment to obtain a stretched film having a width of 400 mm. In this operation, the relax ratio during the heat treatment was constant length in the longitudinal direction (MD direction) of the film and a tensionless state in the perpendicular direction (TD direction). The stretching ratio was 3.0 times in each of the MD and TD directions, and the stretching temperature was 90°C. Various combinations of heat treatment temperatures were employed.

On one side of such a film, an epoxy adhesive (containing 80% by weight of toluene as a solvent) was uniformly applied by means of a bar coater, and toluene was removed at 170°C for 5 minutes. Then, it was press-bonded with an electrolytic copper foil, having a thickness of 35 $\mu$m, between two rollers at 150°C. The soldering heat resistance was determined under the condition of 260°C during 10 seconds. It is evident from the results of the above test shown in Table 1 that an excellent laminated film is obtained when the dry heat shrinkage measured under the condition of 160°C during 15 minutes shows a value of not more than ± 0.5% in each of the longitudinal and transverse directions of the film surface.

T A B L E    1

| | Conditions for heat treatment of the film | | Dry heat shrinkage of the film alone (%) | | Results of the soldering heat resistance test of the laminated film |
|---|---|---|---|---|---|
| | Temp. (°C) | Relax. ratio in TD direction (%) | MD direction | TD direction | |
| Example 1 | 200 | 0 | 0.4 | 0.4 | No abnormality |
| Example 2 | 240 | 0 | 0.2 | 0.2 | No abnormality |
| Example 3 | 240 | 5 | 0.2 | −0.1 | No abnormality |
| Example 4 | 200 | 8 | 0.3 | −0.4 | No abnormality |
| Example 5 | 260 | 0 | 0.1 | 0.1 | No abnormality |
| Comparative Example 1 | 180 | 0 | 1.2 | 1.1 | Film deformed |
| Comparative Example 2 | 180 | 8 | 0.6 | −0.3 | Film deformed |
| Comparative Example 3 | 190 | 0 | 0.6 | 0.6 | Film deformed |

The polyamide laminated film of the present invention is a film having the characteristics of the polytetramethylene adipamide type polyamide effectively utilized and is excellent particularly in heat resistance and dimensional stability.

Claims

1.  A biaxially oriented thermoplastic type laminated film, having a conductive metal layer laminated on at least one side, characterized in that the film comprises a thermoplastic resin composed essentially of polytetramethylene adipamide and wherein the dry heat shrinkage of the film measured after 15 minutes at 160°C, shows a value of at most ± 0,5 % in the longitudinal and transverse direction.

2. Circuit board processed from the film according to claim 1.

3. Film as substantially described in the description and the examples.

4. Process for the production of the biaxially thermoplastic laminated film having a conductive metal layer laminated on at least one side according to claim 1, comprising
   a. the production of a film of a polyamide resin existing essentially of polytetramethyleneadipamide by melt-extrusion at a temperature of between 290 and 330°C, followed
   b. by cooling the film
   c. immersing the non-stretched film in water
   d. simultaneously biaxially stretching the water-conditioned film by a flat method at a temperature of between 50 and 200°C at a stretching ratio in longitudinal and transversal direction of between 1.5 and 5.0 and an area stretching ratio of between 3 and 20 times
   e. subjecting the biaxially stretched film to a heat treatment at a constant temperature of between 200 and 280°C.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | EP-A-0 323 671 (STAMICARBON B.V.)<br>* Page 2, lines 32-41; page 3, lines 7-12 *<br>— — — | 1-3 | H 05 K 1/03 |
| A | DATABASE DERWENT WORLD PATENT INDEX,<br>AN = 90-070283, Derwent Publications Ltd, London, GB;<br>"Polyamide bi axially oriented film-comprises poly-tetramethylene",<br>& JP-A-2 022 032 (UNITIKA LTD) 24-01-1990<br>* Abstract *<br>— — — — — | 1,4 | |

TECHNICAL FIELDS
SEARCHED (Int. Cl.5)

H 05 K
B 32 B

The present search report has been drawn up for all claims

| Place of search | Date of completion of search | Examiner |
|---|---|---|
| The Hague | 10 January 91 | SCHUERMANS N.F.G. |